Europäisches Patentamt

**European Patent Office**

**Office européen des brevets**

(11) Numéro de publication: **0 244 302 B1**

(12) **FASCICULE DE BREVET EUROPEEN**

(45) Date de publication de fascicule du brevet: **15.07.92**  (51) Int. Cl.⁵: **H05K 7/20**

(21) Numéro de dépôt: **87400903.8**

(22) Date de dépôt: **17.04.87**

(54) **Boitier assurant la stabilisation thermique des équipements tels que des composants électroniques qu'il contient.**

(30) Priorité: **21.04.86 FR 8605713**

(43) Date de publication de la demande:
**04.11.87 Bulletin 87/45**

(45) Mention de la délivrance du brevet:
**15.07.92 Bulletin 92/29**

(84) Etats contractants désignés:
**BE CH DE ES GB IT LI NL SE**

(56) Documents cités:
**DE-B- 1 187 284**    **DE-U- 8 130 300**
**US-A- 2 863 994**    **US-A- 2 961 478**
**US-A- 3 187 226**    **US-A- 4 330 812**

(73) Titulaire: **AEROSPATIALE Société Nationale Industrielle**
**37, Boulevard de Montmorency**
**F-75781 Paris Cédex 16(FR)**

(72) Inventeur: **Pedelaborde-Augas, Didier**
**Bidaos-Résidence des Pins Saint Aubin du Médoc**
**F-33160 Saint Medard en Jalles(FR)**
Inventeur: **Pillois, Philippe**
**13, Avenue de Mazeau**
**F-33160 Saint Medard en Jalles(FR)**
Inventeur: **Valy, Yves**
**41, rue Edouard Branley**
**F-33160 Saint Medard en Jalles(FR)**

(74) Mandataire: **Mongrédien, André et al**
**c/o SOCIETE DE PROTECTION DES INVEN-TIONS 25, rue de Ponthieu**
**F-75008 Paris(FR)**

## Description

L'invention concerne un boîtier pour des équipements tels que des composants électroniques comportant des sources de chaleur réparties selon une cartographie donnée. Plus précisément, l'invention concerne un boîtier réalisé pour l'essentiel en un matériau thermiquement isolant et comprenant des moyens de nature passive permettant de dissiper la chaleur dégagée par les équipements qu'il contient.

Bien que l'invention soit particulièrement adaptée au cas d'un boîtier contenant des composants ou des circuits électroniques de natures diverses, elle n'est pas limitée à cette application et couvre tous les cas où des équipements comportant des sources de chaleur sont logés dans un boîtier.

Les sources de chaleur peuvent être constituées aussi bien par les composants actifs tels que les transistors que par les composants passifs tels que les résistances.

Actuellement, les équipements électroniques sont le plus souvent installés dans des boîtiers métalliques. La nature du métal constituant ces boîtiers est généralement déterminée en fonction de l'application envisagée. Les métaux utilisés ont tous en commun une bonne capacité à conduire et à dissiper la chaleur dégagée à l'intérieur du boîtier par les composants électroniques. En appliquant les composants les plus dissipatifs de chaleur contre la paroi du boîtier ou en interposant entre ces composants et la paroi du boîtier une pièce assurant une bonne conductivité thermique, le transfert et la dissipation de la chaleur sont facilement assurés. Une illustration de cet état de la technique est donnée notamment par le brevet US 4 330 812.

Lorsque la chaleur à dissiper est plus importante, des ailettes de refroidissement peuvent être prévues sur la face extérieure de la paroi du boîtier, de façon à augmenter l'efficacité des phénomènes de convexion.

La dissipation de chaleur ainsi obtenue est de nature passive, car elle n'a recours à aucune source d'énergie annexe.

Ces techniques de dissipation de chaleur de nature passive peuvent être complétées le cas échéant par des techniques de nature active lorsque les quantités de chaleur à dissiper dépassent les possibilités offertes par les matériaux utilisés. Parmi ces techniques actives, on citera la ventilation interne ou externe, l'adjonction de modules de Peltier, et l'utilisation de circuits de fluide à changement d'état.

On notera dès à présent que l'invention ne concerne que les techniques de dissipation de chaleur de nature passive. On comprendra que ces techniques peuvent éventuellement être complétées par le recours à certaines techniques de nature active lorsque les quantités de chaleur à dissiper le justifient.

Toutes les techniques de dissipation de chaleur de nature passive connues reposent comme on l'a vu sur l'utilisation d'un boîtier réalisé pour l'essentiel en un matériau thermiquement conducteur.

Cependant, certaines applications peuvent nécessiter d'avoir recours pour la réalisation des boîtiers à des matériaux thermiquement isolants tels que des matériaux composites moulés. Parmi ces applications, on trouve tous les cas où un gain de masse est souhaitable, ce qui est notamment le cas pour les boîtiers des composants électroniques utilisés dans les domaines aéronautique et spatial. L'utilisation de matériaux thermiquement isolants peut aussi être justifiée par leur moindre coût, notamment dans le domaine de l'électronique grand public.

Dans ces applications particulières, les techniques traditionnelles pour assurer la dissipation passive de la chaleur dégagée à l'intérieur des boîtiers ne peuvent pas être utilisées. Il est donc nécessaire d'avoir recours à de nouvelles techniques de dissipation de la chaleur de nature passive, si l'on ne souhaite pas utiliser dans tous les cas aux techniques actives, qui sont par nature lourdes et onéreuses.

L'invention a précisément pour objet un boîtier réalisé pour l'essentiel en un matériau thermiquement isolant, ce boîtier étant équipé de moyens de dissipation de la chaleur de nature passive n'affectant pas de façon significative les caractéristiques justifiant l'utilisation d'un matériau thermiquement isolant, telles que son faible poids et son moindre coût.

A cet effet, il est proposé un boîtier pour des équipements tels que des composants électroniques comportant des sources de chaleur réparties selon une cartographie donnée, ce boîtier comportant une structure mécanique rigide en un matériau thermiquement isolant, cette structure portant des organes passifs de drainage de la chaleur réalisés en un matériau thermiquement conducteur, ces organes étant disposés de telle sorte que chaque source de chaleur est en contact avec l'un de ces organes, caractérisé en ce que les organes de drainage de la chaleur comprennent au moins un implant monté sur la face interne de la structure mécanique rigide.

En choisissant et en dimensionnant les organes de drainage de la chaleur selon la quantité de chaleur dégagée par chaque source et en répartissant judicieusement ces sources, on parvient ainsi à assurer la stabilisation thermique de ces sources, en dépit du caractère thermiquement isolant de la structure.

Les implants peuvent être utilisés lorsque la source de chaleur a une puissance thermique dissipée relativement faible, au maximum d'environ 5W, ce qui est le cas pour de nombreux composants électroniques usuels.

Afin de faciliter la dissipation radiale de la chaleur, chaque implant comporte de préférence des branches orientées radialement ou tangentiellement par rapport à la zone de contact entre une source de chaleur et cet implant.

Lorsque la chaleur dégagée par certaines des sources ne peut être dissipée en totalité par les implants, les organes de drainage de la chaleur comprennent de préférence au moins un insert traversant la structure mécanique rigide et portant un radiateur à l'extérieur de celle-ci.

Dans ce cas, chaque radiateur comporte de préférence des ailettes orientées perpendiculairement à la structure mécanique rigide et régulièrement réparties autour de l'insert.

Dans certaines applications particulières, le boîtier comprend de plus au moins une couche en un matériau assurant la protection des équipements électroniques contre les rayons X. Afin de garantir la continuité de cette protection même à l'emplacement des inserts, ces derniers peuvent alors être réalisés en argent et/ou comporter une augmentation de section en-dessous de la couche de protection contre les rayons X. L'amélioration de la dissipation de chaleur par un film de béryllium recouvrant la face externe de ce matérieu de protection permet alors d'éviter l'émission d'électrons par les parois du boîtier lors d'une irradiation de celui-ci par des rayons X.

Dans un mode de réalisation particulièrement intéressant de l'invention, la structure mécanique rigide est revêtue au moins sur sa face interne d'un film en un matériau thermiquement conducteur. Les inserts et/ou les implants étant en contact avec ce film, celui-ci facilite la dissipation de la chaleur.

De préférence, ce film est réalisé en nickel, en aluminium, en béryllium, en cuivre ou en argent. Il est à noter que ces matériaux, bon conducteurs de l'électricité, donnent également à ce film les caractéristiques d'une cage de Faraday protégeant les composants électroniques contenus dans le boîtier contre les ondes électromagnétiques autres que les rayons X, lorsque le boîtier contient de tels composants.

On décrira maintenant, à titre d'exemples non limitatifs différents modes de réalisation de l'invention en se référant aux dessins annexés dans lesquels :
- la figure 1 est une vue en coupe transversale schématique représentant un boîtier réalisé selon un premier mode de réalisation de l'invention ;
- les figures 2a, 2b et 2b' sont respectivement

une vue de côté et deux vues de face représentant à plus grande échelle deux variantes de réalisation d'un implant monté sur la face intérieure du boîtier pour assurer conformément à l'invention la dissipation de la chaleur dégagée par un composant considéré comme quasi ponctuel présentant un contact réparti avec cet implant ;

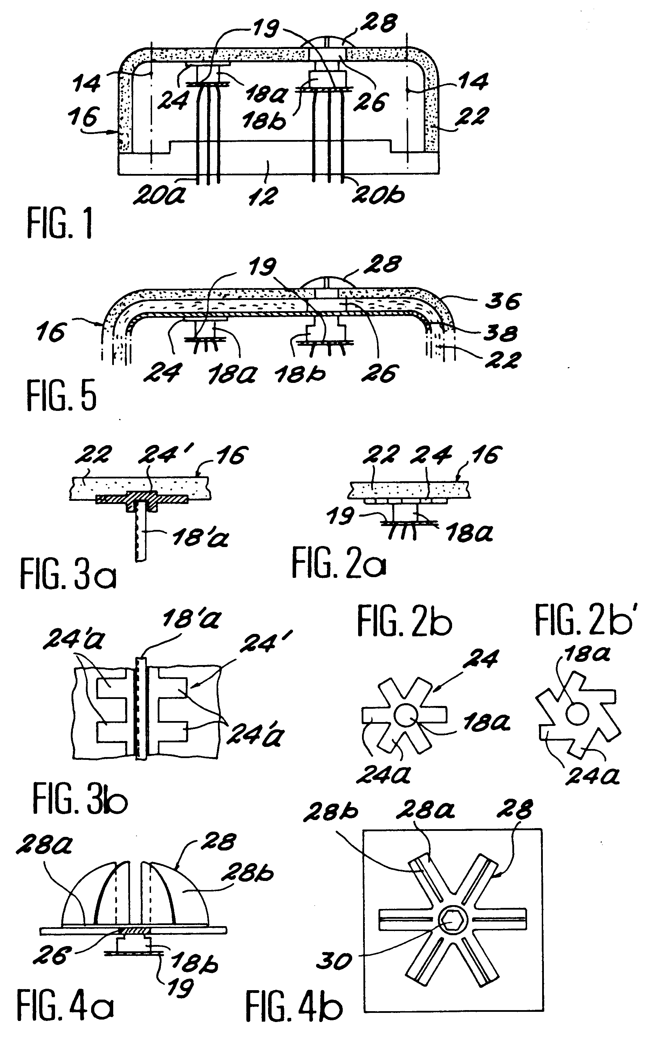

- les figures 3a et 3b sont des vues comparables aux figures 2a et 2b représentant un implant assurant l'évacuation de la chaleur dissipée par un composant en contact quasi linéaire avec cet implant ;
- les figures 4a et 4b sont des vues de côté et de face représentant à plus grande échelle un insert et son radiateur associé assurant conformément à l'invention la dissipation de la chaleur dégagée par un composant dissipant une quantité de chaleur telle qu'un implant ne permettrait pas de l'évacuer en totalité ; et
- la figure 5 est une vue comparable à la figure 1 illustrant un deuxième mode de réalisation de l'invention.

La figure 1 représente de façon trés schématique un boîtier conforme à l'invention. Ce boîtier est désigné de façon générale par la référence 10. Il se compose dans le mode de réalisation représenté d'une embase 12 sur laquelle est fixé un capot 16, par tout moyen approprié tel que des vis (traits mixtes 14 sur la figure 1).

Conformément à l'invention, ce boîtier 10 contient des équipements comportant des sources de chaleur réparties selon une cartographie donnée à l'intérieur du volume clos délimité par le boîtier. Ces équipements peuvent notamment être des composants électroniques actifs ou passifs tels que les composants 18a et 18b sur la figure 1. Ces composants sont connectés électriquement à des composants extérieurs au boîtier par des conducteurs électriques tels que les conducteurs 20a et 20b sur la figure 1, ces conducteurs traversant par exemple l'embase 12.

Dans l'exemple de réalisation représenté sur la figure 1, les composants électroniques tels que 18a et 18b sont maintenus en contact avec des éléments 24, 26 de dissipation thermique, fixés sur la face interne ou dans la structure rigide 22 constituant le capot 16, par tout moyen approprié.

De manière générale, lesdits composants 18a, 18b sont solidaires d'un circuit imprimé 19 lui-même fixé au boîtier par un dispositif approprié et non représenté.

Selon une caractéristique essentielle de l'invention, la structure rigide 22, qui assure la protection mécanique des composants électroniques tels que 18a et 18b, est réalisée en un matériau thermiquement isolant. Cette structure 22 peut notamment être obtenue par moulage à partir d'une matière plastique thermodurcissable telle que la bakélite, les résines polyimides ou les silicones, éventuellement renforcée par des fibres organiques. A titre d'exemple nullement limitatif, on peut utiliser pour fabriquer la structure rigide 22 une résine polyimide renforcée par des fibres de verre orientées de manière aléatoire, commercialisée sous la désignation KINEL 5504 par la Société ...

Parmi les composants contenus dans le boîtier 10, seuls certains d'entre eux constituent des sources de chaleur.

De plus, ces composants qui constituent des sources de chaleur peuvent eux-mêmes être classés en deux catégories, selon que la puissance thermique produite par chaque source est inférieure ou supérieure à la puissance thermique maximum dissipable par le capot 16, pour une surface donnée de celui-ci associée à cette source.

De façon plus précise, après avoir déterminé expérimentalement les paramètres d'échange thermique (coefficient de convection $\alpha$ et émissivité $\epsilon$) du ou des matériaux constituant le capot 16, on calcule la puissance thermique dissipable par ce matériau selon une direction perpendiculaire à la surface du capot, puis on détermine pour chaque type de source de chaleur la loi d'évolution de cette puissance thermique dissipable avec la surface du capot associée à cette source. La forme de cette surface est déterminée par le type de source de chaleur. Ainsi, pour une source quasi ponctuelle, c'est-à-dire dont la surface de contact avec le capot est de petite dimension dans toutes les directions, on associe à la source une surface de forme carrée. Pour une source quasi linéaire, cette surface présente une forme rectangulaire allongée.

La puissance thermique maximum dissipable est déterminée à partir de cette loi d'évolution, pour chaque source de chaleur, en affectant à cette dernière une surface maximum déterminée en tenant compte des sources de chaleur voisines et en fonction de l'échauffement autorisé. Ainsi, on peut associer à une source de chaleur isolée une surface plus grande autorisant une puissance thermique maximum dissipable plus importante que dans le cas de sources rapprochées. Avantageusement, la répartition des sources dans le boîtier est faite en tenant compte de cette observation.

On parvient ainsi à assurer la dissipation par le matériau constituant le capot 16 de la puissance thermique produite par certaines des sources de chaleur logées dans le boîtier.

Cependant, pour une partie de ces sources, la dissipation est généralement insuffisante et il est alors nécessaire d'équiper le boîtier 10 d'accessoires ou organes annexes permettant de dissiper de façon passive la chaleur dégagée à l'intérieur du boîtier par ces sources.

Selon la quantité de chaleur produite par chacune des sources, ces accessoires sont constitués, pour chaque source, soit par un implant appliqué ou moulé sur la surface intérieure de la structure rigide 22, soit par un insert traversant cette structure et auquel est associé un radiateur extérieur. Dans tous les cas, ces différents accessoires sont réalisés en un matériau thermiquement conducteur tel qu'un métal. A titre d'exemple, les implants et les radiateurs peuvent être réalisés en alliages d'aluminium, par exemple de types AU2GN et AU4G1, respectivement, les inserts étant réalisés en cuivre.

Sur la figure 1, le composant 18a constitue une source de chaleur d'intensité relativement faible, bien que nécessitant l'adjonction sur le boîtier d'un accessoire de dissipation de chaleur. La chaleur dégagée par ce composant est donc dissipée en le plaçant en contact avec un implant métallique 24 porté par la surface intérieure du capot 16.

Le composant 18b constitue une source de chaleur d'intensité plus élevée. L'évacuation de cette chaleur est donc assurée en plaçant ce composant en contact avec un insert métallique 26 traversant la paroi du capot 16 et auquel est associé à l'extérieur de ce dernier un radiateur 28.

Les figures 2a, 2b et 2b′ représentent un exemple de réalisation d'un implant 24 conforme à l'invention, dans le cas où la source de chaleur que constitue le composant 18a est quasi ponctuelle. La surface ou zone de contact entre le composant 18a et l'implant 24 est donc relativement limitée dans toutes les directions et, par exemple, circulaire sur la figure 2b. La zone de contact ainsi définie entre le composant 18a et l'implant 24 constitue le centre de ce dernier. Afin de drainer la chaleur dégagée par le composant radialement (figure 2b) ou tangentiellement (figure 2b′) vers l'extérieur, l'implant 24 comporte de plus des branches 24a orientées radialement par rapport à cette zone de contact centrale, et régulièrement réparties autour de cette zone. Dans le mode de réalisation représenté sur la figure 2b, ces branches sont au nombre de six de sorte que l'implant 24 présente la forme d'une étoile à six branches. Le nombre des branches de l'implant peut toutefois être différent de six, et par exemple réduit à quatre si la chaleur dégagée par le composant est plus faible. La configuration des implants est déterminée dans chaque cas particulier, selon l'importance accordée aux facteurs encombrement (surface) et poids (masse), compte tenu de la puissance thermique à évacuer.

Les figures 3a et 3b représentent un exemple de réalisation d'un implant 24′ servant à évacuer la chaleur dégagée par un composant tel qu'une carte 18′a, portant des circuits électroniques, ce composant étant quasi linéaire. Le contact entre le composant 18′a et l'implant 24′ s'effectue donc

selon une surface rectangulaire de grande longueur et relativement étroite.

Dans ce cas, l'implant 24′ comprend une partie centrale rectangulaire entourant la zone de contact entre la carte 18′a et l'implant. L'implant 24′ comprend de plus, de part et d'autre de sa partie centrale, des branches 24′a orientées perpendiculairement à cette partie centrale et régulièrement espacées.

Ces branches assurent ici encore le drainage de la chaleur vers l'extérieur et assurent par conséquent la stabilisation thermique de la carte 18′a, dans la mesure où la configuration de cet implant (forme, masse, surface, ...) est adaptée à la puissance dissipée par cette carte.

Bien entendu, d'autres formes d'implants peuvent être utilisés, notamment dans le cas où la source n'est ni quasi ponctuelle, ni quasi linéaire.

A titre d'exemple, dans le cas d'une charge quasi ponctuelle dissipant une puissance thermique de 2,4W, on pourra utiliser un implant en forme de croix, chaque branche ayant une longnueur de 30mm et une largeur de 10mm, la masse de l'implant étant de 0,7g. Dans le cas d'une charge quasi ponctuelle dissipant une charge de 4W, on utilisera par exemple un implant à 6 branches, les dimensions de chaque paire de branches opposées étant de 60mmx10mm, et la masse de l'implant étant de 2,2g. Cette solution est bien adaptée pour des sources dont la puissance thermique est inférieure à 5W.

La fixation des implants 24, 24′ sur la surface intérieure du capot du boîtier peut être faite par tout moyen approprié. Dans le cas de l'implant 24 sur la figure 2a, celui-ci est représenté comme étant collé sur cette face intérieure. Au contraire, sur la figure 3a, on a représenté l'implant 24′ comme étant inséré en partie dans la structure du boîtier lors du moulage de cette dernière.

Par ailleurs, les implants 24 et 24′ peuvent avantageusement être utilisés pour supporter des composants 18a et 18′a. A cet effet, ces composants sont emboîtés dans lesdits implants (figures 3a et 3b).

Sur les figures 4a et 4b, on a représenté à plus grande échelle un exemple de réalisation d'un insert 26 et de son radiateur associé 28. L'insert 26 est constitué par un bloc métallique, par exemple de cuivre, de forme cylindrique dans le cas d'une source de chaleur de type quasi ponctuel. Ce bloc traverse de part en part la paroi du boîtier 16 et est en contact étroit avec le composant 18b à refroidir. Sur ce bloc métallique peut être fixé à l'extérieur du boîtier le radiateur 28, par tout moyen approprié tel qu'une vis 30. La fixation du radiateur sur l'insert est conçue de façon à assurer une bonne conductivité thermique au niveau du contact.

Le radiateur 28 comprend une semelle 28a, par exemple en forme d'étoile à six branches, plaquée sur l'insert 26 et sur la surface extérieure du boîtier par la vis 30. Cette semelle 28a porte sur chacune de ses branches une ailette 28b en forme de secteur circulaire, faisant saillie perpendiculairement à la face extérieure du boîtier. Les branches de la semelle 28a ainsi que les ailettes 28b sont régulièrement réparties autour de l'axe de l'insert 26.

Bien entendu, les dimensions du bloc métallique constituant l'insert 26, de même que les dimensions de la semelle et des ailettes constituant le radiateur 28 sont déterminées en fonction de la puissance thermique à dissiper. A titre d'exemple, la masse de l'insert de cuivre peut être d'environ 3,9g, pour un rayon de 6mm et la masse du radiateur de 8,2g, chaque paire de branches de la semelle 28a ayant pour dimensions 60mm×10mm et le rayon de chaque ailette 28b étant de 25mm. Une puissance de 10 à 12W peut être dissipée par un tel ensemble, en fonction du T accepté. A titre d'exemple, un T de 60°C amène 7W de dissipation.

Bien entendu, la répartition cartographique des sources de chaleur à l'intérieur du boîtier est déterminée par avance afin que la distance entre ces sources soit d'autant plus importante que la puissance thermique qu'elles dissipent est élevée.

La figure 5 illustre schématiquement un autre mode de réalisation de l'invention selon lequel le capot 16 n'est plus seulement constitué par une structure mécanique rigide 22, mais comprend aussi une couche externe en un matériau 36 servant à assurer une protection des composants logés dans le boîtier 10 contre les rayons X.

Pour plus de détail concernant la constitution et la réalisation de la couche de protection 36, on se réfèrera à la demande de brevet n°8605442 déposée le 16 avril 1986 par l'Aérospatiale (S.N.I.).

Lorsqu'une telle protection contre les rayons X doit être assurée, la continuité de la protection doit être obtenue même au niveau des inserts 26 traversant le matériau assurant ladite protection.

Afin de garantir l'opacité du boîtier aux rayons X, les inserts 26 peuvent être réalisés en argent, ce métal assurant une atténuation satisfaisante pour une épaisseur de boîtier, qui peut être par exemple de 1,73mm, pour un large éventail d'applications.

L'opacité peut aussi être obtenue quel que soit le métal constituant l'insert 26 (cuivre, molybdène, étain, argent, etc...), en garantissant l'épaisseur filtrante nécessaire quelle que soit la trajectoire des photons. Comme l'illustre la figure 5, on augmente à cet effet la section de l'insert 26 en-dessous de la couche protectrice en un matériau 36, c'est-à-dire au niveau de la traversée de la structure 22.

On comprend que la géométrie des inserts 26 définie ci-dessus s'applique également si le matériau constituant la couche externe 36 assure les conditions de rigidité demandées à la stucture 22. Ainsi, dans ce cas, l'augmentation de section de l'insert 26 se situe en-dessous de la paroi de la couche de matériau 36, qui remplit alors simultanément les conditions de rigidité et de protection contre les rayons X, tout en ne garantissant cependant pas de bonnes conditions de conductibilité thermique. On notera que le choix entre l'emploi d'un matériau assurant à la fois rigidité et protection contre les rayons X ou l'emploi de deux matériaux assurant séparément ces fonctions est lié aux niveaux de rigidité et d'opacité aux rayons X que l'on souhaite obtenir.

La figure 5 montre également qu'il est encore possible d'améliorer la stabilisation thermique des sources de chaleur logées dans le boîtier en revêtant au moins en partie la surface intérieure de la structure 22 d'une couche 38 en un matériau thermiquement conducteur tel qu'un métal. Les implants 24 ainsi que les inserts 26 étant au contact de cette couche 38, on comprend que la dissipation thermique est améliorée.

Dans le cas où le boîtier 10 comprend de nombreux inserts 26, une couche en un matériau thermiquement conducteur peut aussi être prévue sur la surface extérieure du boîtier, c'est-à-dire à l'extérieur de la couche 36 sur la figure 5.

L'épaisseur de cette couche 38 peut être par exemple d'environ 0,1mm.

Pour réaliser la ou les couches 38, on utilisera de préférence un métal tel que le nickel, l'aluminium, le béryllium, le cuivre ou l'argent.

Il est à noter que cette couche 38 constitue en outre une cage de Faraday qui permet, en plus de sa fonction de dissipation thermique, d'assurer la protection des circuits contenus à l'intérieur du boîtier contre les ondes électromagnétiques autres que les rayons X.

En outre, lorsqu'une couche telle que la couche 38 est placée à l'extérieur du revêtement 36 et lorsqu'elle est réalisée en béryllium, elle permet, lors d'une irradiation du boîtier par les rayons X, d'éviter l'émission d'électrons par le matériau constituant le revêtement 36 de protection contre les rayons X.

Bien entendu, l'invention n'est pas limitée aux modes de réalisation qui viennent d'être décrits à titre d'exemple mais en couvre toutes les variantes.

En particulier, on a déjà observé que les sources de chaleur placées à l'intérieur du boîtier selon l'invention peuvent être de tous types et ne sont pas limitées à des composants électroniques.

Par ailleurs, il est clair que l'invention est indépendante de la forme donnée au boîtier, cette forme étant essentiellement déterminée en fonction des composants qu'elle contient.

Enfin, une couche en matériau conducteur telle que la couche 38 peut être utilisée quelle que soit la structure présentée par ailleurs par le boîtier. Une ou deux couches telles que la couche 38 peuvent notamment être utilisées dans un boîtier tel que celui qui a été décrit en se référant à la figure 1.

**Revendications**

1. Boîtier pour des équipements tels que des composants électroniques comportant des sources de chaleur (18a, 18b) réparties selon une cartographie donnée, ce boîtier comportant une structure mécanique rigide (22) en un matériau thermiquement isolant, cette structure portant des organes passifs de drainage de la chaleur (24, 24', 26, 28) réalisés en un matériau thermiquement conducteur, ces organes étant disposés de telle sorte que chaque source de chaleur est en contact avec l'un de ces organes, et les organes de drainage de la chaleur comprennent au moins un implant (24, 24') monté sur la face interne de la structure mécanique rigide (22).

2. Boîtier selon la revendication 1, caractérisé en ce que chaque implant (24, 24') comporte des branches (24a, 24'a) orientées radialement ou tangentiellement par rapport à une zone de contact entre une source de chaleur (18a, 18'a) et cet implant.

3. Boîtier selon l'une quelconque des revendications 1 à 2, caractérisé en ce que les organes de drainage de la chaleur comprennent au moins un insert (26) traversant la structure mécanique rigide (22) et portant un radiateur (28) à l'extérieur de celle-ci.

4. Boîtier selon la revendication 3, caractérisé en ce que chaque radiateur (28) comporte des ailettes (28a) orientées perpendiculairement à la structure mécanique rigide (22) et régulièrement réparties autour de l'insert (26).

5. Boîtier selon l'une quelconque des revendications 3 et 4, caractérisé en ce qu'il comprend de plus au moins une couche en un matériau (36) de protection desdits équipements contre les rayons X.

6. Boîtier selon la revendication 5, caractérisé en ce que chaque insert (26) est en argent.

7. Boitîer selon l'une quelconque des revendications 5 et 6, caractérisé en ce que chaque insert (26) comporte une augmentation de section en-dessous de ladite couche en matériau (36) de protection contre les rayons X.

**8.** Boîtier selon l'une quelconque des revendications 1 à 7, caractérisé en ce que la structure mécanique rigide (22) est revêtue au moins sur sa face interne d'un film (38) en un matériau thermiquement conducteur.

**9.** Boîtier selon la revendication 8, caractérisé en ce que le film (38) est réalisé en un matériau choisi dans le groupe comprenant le nickel, l'aluminium, le béryllium, le cuivre et l'argent.

## Claims

**1.** Box for equipment, such as electronic components having heat sources (18a,18b) distributed in accordance with a given cartography, said box having a rigid mechanical structure (22) of a thermally insulating material and carries passive heat draining members (24,24', 26,28) made from a thermally conductive material, said members being arranged in such a way that each heat source is in contact with one of these members and said heat drainage members comprise at least one implant (24,24') mounted on the inner face of the rigid mechanical structure (22).

**2.** Box according to claim 1, characterized in that each implate (24,24') has branches (24a,24'a) oriented radially or tangentially with respect to a contact zone between a heat source (18a,18'a) and said implant.

**3.** Box according to either of the claims 1 and 2, characterized in that the heat draining members comprise at least one insert (26) traversing the rigid mechanical structure (22) and carrying a radiator (28) outside the same.

**4.** Box according to claim 3, characterized in that each radiator (28) has ribs (28a) oriented perpendicularly to the rigid mechanical structure (22) and regularly distributed around the insert (26).

**5.** Box according to either of the claims 3 and 4, characterized in that it also comprises at least one layer of a material (36) for protecting the equipment against X-rays.

**6.** Box according to claim 5, characterized in that each insert (26) is made from silver.

**7.** Box according to either of the claims 5 and 6, characterized in that each insert (26) has a cross-sectional increase below the layer of X-ray protection material (36).

**8.** Box according to any one of the claims 1 to 7, characterized in that the rigid mechanical structure (22) is coated at least on its inner face with a film (38) of thermally conductive material.

**9.** Box according to claim 8, characterized in that the film (38) is made from a material chosen from the group including nickel, aluminium, beryllium, copper and silver.

## Patentansprüche

**1.** Gehäuse für Anlagen, wie etwa elektronische Bauelemente, die Wärmequellen aufweisen (18a, 18b), die entsprechend einer gegebenen Anordnung verteilt sind, wobei das Gehäuse eine mechanisch steife Struktur (22) aus einem thermisch isolierenden Material aufweist, wobei diese Struktur passive Wärmeableitelemente (24, 24', 26, 28) trägt, die aus einem thermisch leitfähigen Material bestehen, wobei diese Elemente so angeordnet sind, daß jede Wärmequelle in Kontakt mit einem dieser Elemente steht, und wobei die Wärmeableitelemente wenigstens einen auf der Innenseite der mechanisch steifen Struktur (22) montierten Einsatz (24, 24') aufweisen.

**2.** Gehäuse nach Anspruch 1, dadurch gekennzeichnet, daß jeder Einsatz (24, 24') Verzweigungen (24a, 24'a) aufweist, die radial oder tangential bezüglich einer Kontaktzone zwischen einer Wärmequelle (18a, 18'a) und diesem Einsatz ausgerichtet sind.

**3.** Gehäuse nach einem der Ansprüche 1 bis 2, dadurch gekennzeichnet, daß die Wärmeableitelemente wenigstens einen Einsatz (26) aufweisen, der die mechanisch steife Struktur (22) durchquert und einen Radiator (28) an deren Äußeren trägt.

**4.** Gehäuse nach Anspruch 3, dadurch gekennzeichnet, daß jeder Radiator (28) Flügel (28a) aufweist, die senkrecht zur mechanisch steifen Struktur (22) ausgerichtet sind und regelmäßig um den Einsatz (26) verteilt sind.

**5.** Gehäuse nach einem der Ansprüche 3 und 4, dadurch gekennzeichnet, daß es außerdem wenigstens eine Schicht aus einem Schutzmaterial (36) für die Anlagen gegen Röntgenstrahlen aufweist.

**6.** Gehäuse nach Anspruch 5, dadurch gekennzeichnet, daß jeder Einsatz (26) aus Silber ist.

7. Gehäuse nach einem der Ansprüche 5 und 6, dadurch gekennzeichnet, daß jeder Einsatz (26) eine Querschnittsverbreiterung unter der Schicht aus Schutzmaterial (36) gegen Röntgenstrahlen besitzt.

8. Gehäuse nach einem der Ansprüche 1 bis 7, dadurch gekennzeichnet, daß die mechanisch steife Struktur (22) wenigstens auf ihrer Innenseite mit einem Film (38) eines thermisch leitenden Materials bedeckt ist.

9. Gehäuse nach Anspruch 8, dadurch gekennzeichnet, daß der Film (38) aus einem Material besteht, das aus der Gruppe ausgewählt ist, welche umfaßt: Nickel, Aluminium, Beryllium, Kupfer und Silber.

FIG. 1

FIG. 5

FIG. 3a

FIG. 2a

FIG. 2b

FIG. 2b'

FIG. 3b

FIG. 4a

FIG. 4b